# EUROPÄISCHE PATENTSCHRIFT

(11) **EP 0 352 764 B1**
(45) Veröffentlichungstag und Bekanntmachung des Hinweises auf die Patenterteilung: **11.01.1995**
(21) Anmeldenummer: 89113777.0
(22) Anmeldetag: 26.07.1989
(51) Int. Cl.: H03J 1/04, H03J 7/18

(54) **Hochfrequenzempfänger mit einer Einrichtung zur Anzeige der Programmkennung von Sendeanstalten**
High-frequency receiver with a device for indicating transmitter programmes
Récepteur pour haute fréquence avec un dispositif d'indication de programme d'émetteurs

(30) Priorität: 29.07.1988 DE 3825812
(43) Veröffentlichungstag der Anmeldung: 31.01.1990
(73) Patentinhaber: Interessengemeinschaft für Rundfunkschutzrechte GmbH Schutzrechtsverwertung & Co. KG., D-40210 Düsseldorf (DE)
(72) Erfinder: Förster, Siegbert, D-8501 Rosstal (DE)

(56) Entgegenhaltungen:
- EP-A- 0 072 943
- EP-A- 0 314 995
- DE-A- 2 746 186
- DE-A- 3 031 527
- DE-A- 3 200 751
- DE-A- 3 441 571

## Beschreibung

Die Erfindung betrifft einen Hochfrequenzempfänger mit einer Einrichtung zur alphanumerischen Anzeige der Programmkennung von Sendeanstalten (beispielsweise NDR 3 = drittes Programm des Norddeutschen Rundfunks), mit einer Dekodierschaltung, die von dem empfangenen Sender gegebenenfalls ausgestrahlte, die Programmkennung der zugehörigen Sendeanstalt enthaltende Zusatzsignale, insbesondere nach dem Radio-Daten-System (RDS), auswertet, mit einem Digitalspeicher, in welchem eine erste und eine zweite Tabelle gespeichert sind, in denen den Sendern zugeteilten Standortnummern die zugehörigen Sendefrequenzen bzw. die Programmkennungen der zugehörigen Sendeanstalten zugeordnet sind, und mit einem Mikroprozessor, der bei Empfang eines unbekannten Senders, der keine Zusatzsignale ausstrahlt, die Sendefrequenz des unbekannten Senders mit den Sendefrequenzen der ersten Tabelle vergleicht, aus der ersten Tabelle diejenige Standortnummer ermittelt, deren Sendefrequenz mit der des unbekannten Senders übereinstimmt und die einem in dem Empfangsbereich des Empfängerstandortes liegenden Sender zugeordnet ist, aus der zweiten Tabelle die zu dieser Standortnummer gehörende Programmkennung ermittelt und der Anzeigeeinrichtung zuführt.

Aus der EP-A- 0 072 943 ist ein Abstimmsystem bekannt, bei dem der Standart von Sendern mit RDS als auch von Sendern ohne RDS bestimmt bestimmt wird.

Aus der DE-A- 27 46 186 ist ein Verfahren zur alphanumerischen Anzeige der Programmkennung von Sendeanstalten in einem Hochfrequenzempfänger bekannt, wobei dessen Oszillatorfrequenz mit dem Inhalt von vorprogrammierten Plätzen eines Speichers in einem Mikroprozessor verglichen und bei Übereinstimmung mit dem Inhalt eines der Speicherplätze die Programmkennung der Sendeanstalt in einer Anzeigeeinrichtung angezeigt wird.

Eine solche Anzeige erfolgt beispielsweise unmittelbar nach dem Ablauf eines automatischen Suchlaufvorganges.

Dieses bekannte Verfahren arbeitet nicht immer zufriedenstellend. Wegen der Ausstrahlung desselben Programms durch mehrere, an verschiedenen Standorten aufgestellte Sender derselben Sendeanstalt auf verschiedenen Sendefrequenzen ist eine eindeutige Zuordnung der einzelnen Sendefrequenzen zu jeweils einer bestimmten Sendeanstalt nicht möglich. So kann man im UKW-Bereich beispielsweise auf der Frequenz 92,4 MHz das erste Programm des NDR und auch das erste Programm des SWF (Südwestfunk) empfangen. Zeigt die Frequenzanzeige des Empfängers 92,4 MHz an, würde im norddeutschen Raum das erste Programm des NDR, im süddeutschen Raum dagegen das erste Programm des SWF empfangen werden. Eine für diese beiden Empfangsbereiche gleichermaßen gültige Vorprogrammierung für eine alphanumerische Anzeige der Sendeanstalt kann daher aus der Sendefrequenz allein nicht verwirklicht werden.

Dieses bekannte Verfahren wird in der DE-A-30 31 527 dadurch verbessert, daß in weiteren Speichern Tabellen mit einer Leistungskennung und einer Standortnummer für die Sender entsprechend ihrer geographischen Verteilung gespeichert und den Tabellen für die Programmkennungen und die Frequenzen der Sendeanstalten zugeordnet werden und daß nach Abstimmung des Empfangsteils des Empfängers die Inhalte der elektronischen Tabellen innerhalb eines begrenzten Tabellenabschnittes, welcher nach Eingabe der Standortnummer des dem Empfangsort nächstgelegenen Senders bestimmt wird, auf Übereinstimmung mit den Kenndaten der Empfangsfrequenz kontrolliert werden und im Fall der Übereinstimmung die zugehörige, die Sendeanstalt kennzeichnende Programmkennung an eine Anzeigeeinrichtung übertragen wird. Dabei erfolgt die Eingabe der Standortnummer des dem Empfangsort nächstgelegenen Senders über die mit einer zusätzlichen Taste für diesen Vorgang aktivierte Tastatur der Frequenzeingabe oder über eine zusätzliche Tastatur.

Dieses Verfahren hat den Nachteil, daß beispielsweise ein Autofahrer bei einer Fahrt über größere Entfernungen jedesmal, wenn er das Empfangsgebiet des gerade empfangenen Senders verläßt, mit der zusätzlichen Tastatur den dem neuen Empfängerstandort am nächsten liegenden Sender eingeben muß, nachdem er ihn aus irgend einer Tabelle herausgesucht hat. Dieser Vorgang ist sehr umständlich und erfordert möglicherweise sogar ein Anhalten auf einem Parkplatz, um diese Manipulation in Ruhe vornehmen zu können.

Aus einer Veröffentlichung der European Broadcasting Union (EBU) unter der Bezeichnung "Tech. 3244-E" vom März 1984 mit dem Titel "Specifications of the radio data systems RDS for VHF/FM sound broadcasting" ist ein Verfahren zur alphanumerischen Anzeige der Programmkennung von Sendeanstalten bekannt, bei dem die Sender digitale, diese Programmkennung enthaltende Zusatzsignale ausstrahlen, die in das senderseitige Modulationsspektrum eingefügt sind und so zum Empfänger übertragen werden. Dieses Radio-Daten-System (RDS) soll eventuell in der Zukunft als europäische Norm eingeführt werden.

Dieses System vermeidet auf einfache Weise alle Nachteile der vorstehend erläuterten Verfahren und erlaubt ohne Zutun des Benutzers jederzeit und in jedem Empfangsgebiet die automatische Ermittlung und alphanumerische Anzeige der Sendeanstalten, die mit diesem System ausgerüstet sind.

Leider ist in absehbarer Zukunft nicht damit zu rechnen, daß alle Sendeanstalten das Radio-Daten-System einführen werden. Vielmehr werden viele Sender, insbesondere kleinere Regionalsender, dieses System erst wesentlich später oder überhaupt nicht einführen, so daß ein lückenloses Funktionieren dieses an sich guten Systems mit den bisher bekannten Verfahren nicht erreicht werden kann.

Aus der DE-OS 34 41 571 ist ein Hochfrequenzempfänger der eingangs erwähnten Art bekannt, der eine alphanumerische Anzeige der Programmkennung sowohl von Sendeanstalten, die diese Kennung enthaltende Zusatzsignale ausstrahlen, als auch von Sendeanstalten ohne diese Zusatzsignale aufweist. Dabei ist ein von diesen Zusatzsignalen gesteuerter Umschalter vorgesehen, der automatisch von der Auswertung durch den Mikroprozessor (bei Empfang einer Sendeanstalt ohne Zusatzsignale) auf die Auswertung durch die Dekodierschaltung (bei Empfang einer Sendeanstalt mit Zusatzsignalen) umschaltet.

Dieser Hochfrequenzempfänger hat jedoch den Nachteil, daß in den Fällen des Empfangs von Sendeanstalten ohne Zusatzsignale die Auswertung nur für jeweils einen Empfangsbereich funktioniert. Auch hier muß also, ähnlich wie bei den anderen vorstehend erläuterten bekannten Verfahren, der Standort des Empfängers oder ein in der Nähe befindlicher Senderstandort eingegeben werden, um den Empfangsbereich festzulegen. Andernfalls ist wegen der Mehrfachbelegung von gleichen Sendefrequenzen durch verschiedene Sendeanstalten eine eindeutige Erkennung und Anzeige von empfangenen Sendeanstalten ohne RDS nicht möglich.

Der Erfindung liegt deshalb die Aufgabe zugrunde, einen Hochfrequenzempfänger anzugeben, mit dem innerhalb sämtlicher Empfangsgebiete, in denen irgendwelche die Zusatzsignale ausstrahlende Sendeanstalten vorhanden sind, beliebige Sendeanstalten, die keine Zusatzsignale ausstrahlen, einwandfrei erkennbar und alphanumerisch anzeigbar sind, ohne irgendwelche Eingaben von Hand vornehmen zu müssen, auch dann nicht, wenn der Empfänger, zum Beispiel in einem Fahrzeug, viele verschiedene Empfangsbereiche durchfährt.

Diese Aufgabe wird nach dem Kennzeichen des Patentanspruchs 1 dadurch gelöst, daß der Mikroprozessor den Empfängerstandort oder dessen Empfangsbereich durch Auswerten der Zusatzsignale eines anderen, vorzugsweise des stärksten bzw. mit bester Qualität am Empfängerstandort empfangbaren, diese Zusatzsignale ausstrahlenden Senders (Vergleichssender) ermittelt.

Weitere vorteilhafte Ausgestaltungen der Erfindung sind in den Unteransprüchen angegeben.

Die mit der Erfindung erzielten Vorteile bestehen insbesondere darin, daß in den Empfangsbereichen, in denen wenigstens ein Sender vorhanden ist, der eine Programmkennung enthaltende Zusatzsignale ausstrahlt, alle übrigen Sendeanstalten, deren Sender keine Zusatzsignale ausstrahlen, einwandfrei ermittelt und ihre Programmkennung auf einer Anzeigeeinrichtung abgelesen werden können.

Ein Ausführungsbeispiel der Erfindung wird im folgenden näher beschrieben. Ein Hochfrequenzempfänger der gehobenen Klasse, insbesondere ein UKW-Kraftfahrzeug-Rundfunkempfänger, besitzt eine Einrichtung zur alphanumerischen Anzeige der Programmkennung von Sendeanstalten. Empfängt er beispielsweise das dritte Programm des Norddeutschen Rundfunks, so lautet die Anzeige "NDR 3".

Zur Steuerung dieser Anzeige verfügt der Empfänger über eine Dekodierschaltung, die von dem empfangenen Sender gegebenenfalls ausgestrahlte, die Programmkennung der zugehörigen Sendeanstalt enthaltende Zusatzsignale, beispielsweise nach dem Radio-Daten-System (RDS), auswertet.

Für die Anzeige aller übrigen Sendeanstalten benötigt der Empfänger einen Digitalspeicher, in welchem drei Tabellen gespeichert sind, in denen den den Sendern zugeteilten Standortnummern jeweils die zugehörigen Sendefrequenzen bzw. die Programmkennungen der zugehörigen Sendeanstalten bzw. Listen derjenigen Standortnummern zugeordnet sind, deren Sender jeweils an den zu jenen Standortnummern gehörenden Senderstandorten empfangbar sind.

Ferner ist in dem Empfänger ein Mikroprozessor vorhanden, der bei Empfang eines unbekannten Senders, der keine Zusatzsignale ausstrahlt, nacheinander folgende Verfahrensschritte durchführt:
- er stimmt den Empfänger auf einen der stärksten bzw. qualitativ besten Sender ab, der die Programmkennung enthaltende Zusatzsignale ausstrahlt (RDS-Sender), stellt dessen Sendefrequenz fest und ermittelt dessen Programmkennung durch Dekodieren dieser Zusatzsignale in einer Dekodierschaltung,
- er ermittelt aus der ersten und der zweiten Tabelle die zu der Sendefrequenz und der Programmkennung dieses RDS-Senders gehörende Standortnummer,
- er ermittelt aus der dritten Tabelle alle der Standortnummer dieses RDS-Senders zugeordneten Standortnummern,
- er ermittelt aus der ersten Tabelle unter diesen Standortnummern diejenige Standortnummer, deren zugehörige Sendefrequenz mit der des unbekannten Senders übereinstimmt, und
- er ermittelt aus der zweiten Tabelle die zu dieser Standortnummer gehörende Programmkennung und führt diese der alphanumerischen Anzeigeeinrichtung zu.

Diese Einrichtung zeigt nun den Namen der Sendeanstalt und gegebenenfalls die Nummer des Programms an, wobei der Empfänger automatisch wieder auf die Sendefrequenz des ursprünglich unbekannten Senders abgestimmt wird. Damit ist der Identifikationsvorgang beendet, und der Benutzer kann das gewählte Programm hören und gleichzeitig ablesen, von welcher Sendeanstalt dieses Programm kommt.

## Patentansprüche

1. Hochfrequenzempfänger mit einer Einrichtung zur alphanumerischen Anzeige der Programmkennung von Sendeanstalten (beispielsweise NDR 3 = drittes Programm des Norddeutschen Rundfunks),
- mit einer Dekodierschaltung, die von dem empfangenen Sender gegebenenfalls ausgestrahlte, die Programmkennung der zugehörigen Sendeanstalt enthaltende Zusatzsignale, insbesondere nach dem Radio-Daten-System (RDS), auswertet,
- mit einem Digitalspeicher, in welchem eine erste und eine zweite Tabelle gespeichert sind, in denen den Sendern zugeteilten Standortnummern die zugehörigen Sendefrequenzen bzw. die Programmkennungen der zugehörigen Sendeanstalten zugeordnet sind, und
- mit einem Mikroprozessor, der bei Empfang eines unbekannten Senders, der keine Zusatzsignale ausstrahlt,
- die Sendefrequenz des unbekannten Senders mit den Sendefrequenzen der ersten Tabelle vergleicht,
- aus der ersten Tabelle diejenige Standortnummer ermittelt, deren Sendefrequenz mit der des unbekannten Senders übereinstimmt und die einem in dem Empfangsbereich des Empfängerstandortes liegenden Sender zugeordnet ist,
- aus der zweiten Tabelle die zu dieser Standortnummer gehörende Programmkennung ermittelt und der Anzeigeeinrichtung zuführt,
**dadurch gekennzeichnet**, daß der Mikroprozessor den Empfängerstandort oder dessen Empfangsbereich durch Auswerten der Zusatzsignale eines anderen, vorzugsweise des stärksten bzw. mit bester Qualität am Empfängerstandort empfangbaren, diese Zusatzsignale ausstrahlenden Senders (Vergleichssender) ermittelt.

2. Hochfrequenzempfänger nach Anspruch 1, dadurch gekennzeichnet, daß in dem Digitalspeicher eine dritte Tabelle gespeichert ist, in der jeder Standortnummer diejenigen Standortnummern zugeordnet sind, deren Sender an dem zu jener Standortnummer gehörenden Senderstandort empfangbar sind.

3. Hochfrequenzempfänger nach Anspruch 2, dadurch gekennzeichnet, daß der Mikroprozessor
- den Empfänger auf den Vergleichssender abstimmt, seine Sendefrequenz feststellt und aus den Zusatzsignalen seine Programmkennung ermittelt,
- aus der ersten und der zweiten Tabelle die zu der Sendefrequenz und zu der Programmkennung des Vergleichssenders gehörende Standortnummer ermittelt,
- aus der dritten Tabelle alle der Standortnummer des Vergleichssenders zugeordneten Standortnummern ermittelt und
- aus der ersten Tabelle unter diesen Standortnummern diejenige Standortnummer ermittelt, deren zugehörige Sendefrequenz mit der des unbekannten Senders übereinstimmt.

4. Hochfrequenzempfänger nach Anspruch 2 oder 3, dadurch gekennzeichnet, daß die dritte Tabelle die jeder Standortnummer zugeordneten Standortnummern in Form von Listen enthält.

5. Hochfrequenzempfänger nach Anspruch 4, dadurch gekennzeichnet, daß die Listen nur Standortnummern von Sendern enthalten, die keine Zusatzsignale ausstrahlen.

6. Hochfrequenzempfänger nach Anspruch 4 oder 5, dadurch gekennzeichnet, daß die Listen nur solchen Standortnummern zugeordnet sind, deren Sender ihre Programmkennung enthaltende Zusatzsignale ausstrahlen.

7. Hochfrequenzempfänger nach Anspruch 2 oder 3, dadurch gekennzeichnet, daß die dritte Tabelle die Standortnummern in Form einer Matrix entsprechend ihrer geographischen Verteilung enthält.

8. Hochfrequenzempfänger nach einem der Ansprüche 1 bis 7, dadurch gekennzeichnet, daß die erste Tabelle mit der zweiten Tabelle zu einer gemeinsamen Tabelle vereinigt ist, in der jeder Standortnummer die zugehörige Sendefrequenz und die Programmkennung der zugehörigen Sendeanstalt zugeordnet sind.

9. Hochfrequenzempfänger nach einem der Ansprüche 4 bis 6, dadurch gekennzeichnet, daß die dritte Tabelle mit der ersten und der zweiten Tabelle zu einer gemeinsamen Tabelle vereinigt ist, in der jeder Standortnummer die zugehörige Sendefrequenz, die Programmkennung der zugehörigen Sendeanstalt und gegebenenfalls eine Liste mit Standortnummern zugeordnet sind, deren Sender an dem zu jener Standortnummer gehorenden Senderstandort empfangbar sind.

## Claims

1. High-frequency receiver with an equipment for the alphanumeric display of the programme identification of transmitting stations (for example NDR 3 = third programme of the North German Radio),
- with a decoding circuit which evaluates the additional signals which are in a given case radiated by the received transmitting station and contain the programme identification of the associated transmitting station, in particular according to the radio data system (RDS),
- with a digital storage device, in which a first and a second table are stored, in which the location numbers allotted to the transmitters are associated with the respective transmitting frequencies or the programme identifications of the respective transmitting stations and
- with a microprocessor which on reception of an unknown transmitter, which does not radiate any additional signals,
- compares the transmitting frequency of the unknown transmitter with the transmitting frequencies of the first table,
- ascertains that location number from the first table, the transmitting frequency of which agrees with that of the unknown transmitter and which is associated with a transmitter lying in the receiving range of the receiver location,
- ascertains the programme identification belonging to this location number from the second table and feeds it to the display equipment,
characterised thereby, that the microprocessor ascertains the receiver location or its receiving range by evaluation of the additional signals of another transmitter (comparison transmitter), which radiates these additional signals and is preferably the strongest one or the one receivable with best quality at the receiver location.

2. High-frequency receiver according to claim 1, characterised thereby, that a third table, in which each location number is associated with those location numbers, the transmitters of which are receivable at the transmitter location belonging to that location number, is stored in the digital storage device.

3. High-frequency receiver according to claim 2, characterised thereby, that the microprocessor
- tunes the receiver to the comparison transmitter, ascertains its transmitting frequency and ascertains its programme identification from the additional signals,
- ascertains the location number belonging to the transmitting frequency and to the programme identification of the comparison transmitter from the first and the second table,
- ascertains all location numbers associated with the location number of the comparison transmitter from the third table and
- among these location numbers ascertains from the first table that location number, the respective transmitting frequency of which agrees with that of the unknown transmitter.

4. High-frequency receiver according to claim 2 or 3, characterised thereby, that the third table contains the location numbers associated with each location number in the form of lists.

5. High-frequency receiver according to claim 4, characterised thereby, that the lists contain only location numbers of transmitters which do not radiate additional signals.

6. High-frequency receiver according to claim 4 or 5, characterised thereby, that the lists are associated only with such location numbers, the transmitters of which radiate additional signals containing their programme identification.

7. High-frequency receiver according to claim 2 or 3, characterised thereby, that the third table contains the location numbers in the form of a matrix corresponding to their geographical distribution.

8. High-frequency receiver according to one of the claims 1 to 7, characterised thereby, that the first table is combined with the second table into a common table, in which each location number is associated with the respective transmitting frequency and the programme identification of the respective transmitting station.

9. High-frequency receiver according to one of the claims 4 to 6, characterised thereby, that the third table is combined with the first and the second table into a common table, in which each location number is associated with the respective transmitting frequency, the programme identification of the respective transmitting station and in a given case a list with location numbers, the transmitters of which are receivable at the transmitter location belonging to that location number.

## Revendications

1. Récepteur haute fréquence comportant un dispositif pour l'affichage alphanumérique de l'indicatif de programme d'organismes d'émission (par exemple NDR 3 = troisième programme de la Norddeutsche Rundfunk ou Radiodiffusion de l'Allemagne du Nord), possédant
- un circuit décodeur exploitant les signaux additionnels éventuellement émis par l'émetteur reçu et contenant l'indicatif de programme de l'organisme d'émission concerné, en particulier selon le système de données de radiodiffusion RDS (Radio-Data-System),
- une mémoire numérique dans laquelle sont stockées une première et une deuxième table, dans lesquelles figurent les numéros de stations (emplacements) attribués aux émetteurs avec les fréquences d'émission respectivement les indicatifs de programme correspondants des organismes d'émission concernés, et
- un microprocesseur qui, à la réception d'un émetteur inconnu n'émettant pas de signaux additionnels,
- compare la fréquence d'émission de l'émetteur inconnu avec les fréquences d'émission de la première table,
- détermine à l'aide de la première table les numéros de stations dont la fréquence d'émission concorde avec celle de l'émetteur inconnu et qui est coordonné à un émetteur situé dans la zone de réception correspondant à la position du récepteur,
- détermine à l'aide de la deuxième table l'indicatif de programme appartenant à ce numéro de station et l'applique au dispositif d'affichage,
caractérisé en ce que le microprocesseur détermine la position du récepteur ou sa zone de réception par exploitation des signaux additionnels d'un autre émetteur (émetteur témoin), de préférence de l'émetteur le plus puissant, ou pouvant être reçu avec la meilleure qualité à la position du récepteur, qui émet ces signaux additionnels.

2. Récepteur haute fréquence selon la revendication 1, caractérisé en ce qu'une troisième table est stockée dans la mémoire numérique, dans laquelle sont coordonnés, à chaque numéro de station, les numéros de stations dont les émetteurs peuvent être reçus à la station d'émetteur appartenant à ce numéro de station.

3. Récepteur haute fréquence selon la revendication 2, caractérisé en ce que le microprocesseur
- accorde le récepteur sur l'émetteur témoin, établit sa fréquence d'émission et détermine son indicatif de programme à partir des signaux additionnels,
- détermine, à l'aide de la première et de la deuxième table, le numéro de station appartenant à la fréquence d'émission et à l'indicatif de programme de l'émetteur témoin,
- détermine à l'aide de la troisième table tous les numéros de stations coordonnés au numéro de station de l'émetteur témoin et
- détermine à l'aide de la première table, sous ces numéros de stations, le numéro de station dont la fréquence d'émission coordonnée concorde avec celle de l'émetteur inconnu.

4. Récepteur haute fréquence selon la revendication 2 ou 3, caractérisé en ce que la troisième table contient les numéros de stations coordonnés à chaque numéro de station sous la forme de listes.

5. Récepteur haute fréquence selon la revendication 4, caractérisé en ce que les listes contiennent seulement des numéros de stations d'émetteurs n'émettant pas de signaux additionnels.

6. Récepteur haute fréquence selon la revendication 4 ou 5, caractérisé en ce que les listes sont seulement coordonnées aux numéros de stations dont les émetteurs émettent des signaux additionnels contenant leur indicatif de programme.

7. Récepteur haute fréquence selon la revendication 2 ou 3, caractérisé en ce que la troisième table contient les numéros de stations sous la forme d'une matrice correspondant à leur répartition géographique.

8. Récepteur haute fréquence selon une des revendications 1 à 7, caractérisé en ce que la première et la deuxième table sont rassemblées en une table commune dans laquelle sont coordonnés, à chaque numéro de station, la fréquence d'émission correspondante et l'indicatif de programme de l'organisme d'émission concerné.

9. Récepteur haute fréquence selon une des revendications 4 à 6, caractérisé en ce que la troisième table est rassemblée avec la première et la deuxième table en une table commune dans laquelle sont coordonnés, à chaque numéro de station, la fréquence d'émission correspondante, l'indicatif de programme de l'organisme d'émission concerné et, éventuellement, une liste de numéros de stations dont les émetteurs peuvent être reçus dans la région d'émetteur appartenant à ce numéro de station.
